# EUROPEAN PATENT SPECIFICATION

(11) **EP 4 560 702 B1**
(45) Date of publication and mention of the grant of the patent: **29.07.2026**
(21) Application number: 23212157.4
(22) Date of filing: 26.11.2023
(51) Int. Cl.: H02M 7/00, H10W 44/00, H10W 70/65, H10W 72/00, H10W 72/60, H10W 90/00, H10W 40/25

(54) **POWER MODULE AND THE PROCESS OF PRODUCING A POWER MODULE**
LEISTUNGSMODUL UND VERFAHREN ZUR HERSTELLUNG EINES LEISTUNGSMODULS
MODULE DE PUISSANCE ET PROCÉDÉ DE FABRICATION D'UN MODULE DE PUISSANCE

(43) Date of publication of application: 28.05.2025
(73) Proprietor: Bayerische Motoren Werke Aktiengesellschaft, 80809 München (DE)
(72) Inventor: JI, Chao, Nottingham NG9 2AS (GB); BURTON, Christian, Caerphilly CF83 1EJ (GB); VILLARRUEL-PARRA, Alejandro, 3919 Porsgrunn (NO); BOCK, David, 85669 Pastetten (DE)
(74) Representative: HGF

(56) References cited:
- US-A1- 2021 210 422
- US-B2- 11 031 379

## Description

The invention relates to power module and the process of producing a power module.

It is generally known that current flowing through an electrical conductor induces a magnetic field. A changing magnetic field in turn induces a current in an electrical conductor.

If the current flowing through a circuit changes, for example when it is switched on or off, the magnetic flux through the circuit is changed. This also induces a current. Thus, when the circuit is switched on, the current only increases gradually until it reaches the maximum, and when the circuit is switched off, the current also needs a certain amount of time until it runs out.

Such self-inductance is particularly dangerous in high current applications with switching character, such as power semiconductors in half-bridge configuration, since high currents flow here and very high peaks in current and voltage are often generated by the high switching frequencies. These can be destructive to the connected components.

Such components for high current applications are often mass products and are manufactured in large numbers.

On the website https://resources.altium.com/DE/P/parasitaere-Induktivitaeten-und-Leistungshalbleiter-eine-unglueckliche-Paarung, under the title "parasitaere Induktivitaeten und Leistungshalbleiter eine unglueckliche Paarung" (English: "Parasitic inductors and power semiconductors - an unfortunate pairing"), by Florian Störmer, generated on August 27, 2019 and updated on October 14, 2020, it is explained how in PCB design parasitic inductors lead to EMI problems. This is a significant problem especially in the context of power semiconductors, such as MOSFETs or IGBTs and SiC MOSFETs in particular, and often negates the advantage of high switching frequencies and the associated loss reduction. In principle, the areas spanned by current paths should be kept as small as possible. The placement of decoupling capacitors can also make sense.

WO 2018/007,062 A1 discloses a low-inductance power module in which busbars are arranged one above the other.

CN 111,092,049 A discloses an all-copper interconnection packaging scheme for ceramic substrate.

Power modules with stacked busbars are known from US2020235558A1, WO2020191960A1, CN112750803A, US10283447B1. , US 11 031 379 B2, and US 2021/210422 A1. Q. Zhu, A. Forsyth, R. Todd and L. Mills, "Thermal characterisation of a copper-clip-bonded IGBT module with double-sided cooling," 2017 23rd International Workshop on Thermal Investigations of ICs and Systems (THERMINIC), 2017, pp. 1-6, doi:
10.1109/THERMINIC.2017.8233804) shows that bonding wires can be replaced by a copper clip to reduce parasitic induction.

Thus, it is an object of the present invention to provide an power module that produces only a low parasitic induction.

A further task of the invention is to produce, by simple means, a power module for high current applications which can be manufactured in large numbers.

One or more tasks are solved by the objects of the independent claims. Advantageous further developments and preferred embodiments form the subject-matter of the sub-claims.

A power module comprises at least one semiconductor chip for high current applications arranged on a carrier board. The semiconductor chip is electrically connected via conductor tracks to two busbars which comprise external contact tongues to be connected to power supply lines. The busbars are arranged closely adjacent to one another in order to avoid parasitic induction and the current flow in the two busbars being aligned in an anti-parallel manner. The busbars comprise internal contact tongues. The internal contact tongues of the different busbars are connected to different electrically conducting substrate sections so that the different substrate sections can be connected to the at least one semiconductor chip via pairwise arranged adjacent and in parallel conductor tracks in order to avoid parasitic induction. The current flow in the pairwise arranged conductor tracks is aligned in an anti-parallel manner.

Substrates or substrate sections are conductive areas within the power module, which can be separated by a gap from each other.

Due to the internal contact tongues different substrates, which are locally separated from each other, can be addressed. By connect the substrates to parallel conductor tracks, the path of the electric current flows through the conductor tracks in both, antiparallel directions, the distance between the two directions can be minimised.

Furthermore, the busbars conduct the current in an antiparallel manner as well and are arranged closely adjacent to each other, so that no or only a low parasitic induction occurs in the area of the busbars.

Even the internal contact tongues for both busbars can be placed parallel to each other, that no or only a low parasitic induction occurs in the area of the internal contact tongues.

Parasitic induction is reduced by decreasing the area between the anti-parallel conductors and busbars.

By placing the conduction tracks and busbars in a parallel manner, the cross-section in between each the conduction tracks and busbars is minimised. This is the most effective way to prevent or reduce parasitic induction.

Due to the parallel conductor tracks in sections and parallel busbars, the parasitic inductions are effectively prevented, even if several components are provided. This prevents a parasitic induced signal from amplifying itself from component to component. A destruction of a component, such a semiconductor chip, can be avoided.

Addressing the substrates via the internal contact tongues enables the possibility to define the way of the current in a three-dimensional space, rather than in just two dimensions, if one way of the current is via a layer, which covers large parts of the power module. This degree of freedom allows to bring the conductor tracks closer to each other, which will reduce the parasitic induction.

Conductor tracks electrically connect two parts of a component. These can be semiconductor chips or contact surfaces, for example.

An electrical component is a part of an electrical circuit that cannot be physically subdivided further without losing its properties. This may be, for example, a half-bridge for power semiconductors.

Preferable the conductor tracks are pairwise arranged adjacent and in parallel in order to avoid parasitic induction and the current flow in the pairwise arranged conductor tracks is aligned in an anti-parallel manner and each conductor track is formed from a metal plate.

The fact that the conductor tracks are made of a metal plate increases the cross-section of these conductor tracks compared to wires. The larger the cross-section of a conductor track, the smaller the current density and the smaller the parasitic induction. Additionally, more current can be transported by the conductor tracks compared to a single bond wire.

Furthermore, conductor tracks as metal plates have a very beneficial thermal characterisation due to the large surface. It can help to cool the electrical connection by thermal radiation.

A metal plate is a product made of a metal whose width is much greater than its thickness.

Preferably, the connections to the semiconductor chip and to the busbars of the conductor tracks are each formed by means of a sintered interconnection structure an electrical and mechanical connection.

The sintered connection has the advantage that the individual conductor tracks can be attached one after the other. Simultaneous attachment, such as with soldering, is not necessary here.

The simultaneous attachment of soldered connections is due to the fact that the temperature for attaching and detaching is the same, namely the temperature of the solder to melt. If one soldered a second connection element after a first one, there would be a risk that the first one would come loose again during the soldering process.

According to a preferred embodiment, one of the conductor tracks is arranged at least substantially between another conductor track and the surface of a carrier board on which the at least one semiconductor chip is located, wherein the conductor tracks are at least partially anti-parallel, so that the parasitic induction induced by the current flow in the conductor tracks substantially cancel each other out.

By placing the conduction tracks in a parallel manner, the connecting tracks overlap in length and width and the volume is minimised. This is the most effective way to prevent parasitic induction.

Preferably, each electrical connection of the electrical interconnection structure is a conductor track.

This means that all electrical connections from a current input to a current output are connected by a conductor track.

The electrical interconnection structure may be one of several interconnection structures in the electrical component. An electrical interconnection structure traces the path of a circuit from a current source to a current sink.

Individual electrical connections for control can be designed as wirebonds.

Furthermore, the electrical interconnection structure can be designed in such a way that the interconnection conductors are electrically and mechanically connected to the semiconductor chip by means of a sintered interconnection structure.

The sintered connection has the advantage that the individual conductor tracks can be attached one after the other as discussed above.

Preferably, the electrical component is an integrated circuit.

Integrated circuits have the advantage that they are protected from external influences, such as humidity, heat or shock, so that the internal components do not break.

According to a preferred embodiment, the conductor tracks have a height and a width perpendicular to the direction of the current, whereby the height essentially points away from the carrier board and the width is greater than the height. Preferably it is at least 10 times larger and in particular at least 100 times larger.

Such dimensions are easily created by the metal plate property. Plate-like conductor tracks are formed as a result.

On the one hand, such plate-like conductor tracks are dimensionally stable, but they can also transport larger amounts of current than, for example, bondwires.

Preferably, the distance between the two conductor tracks is not greater than 1 mm, preferably not greater than 0.5 mm and in particular not greater than 0.1 mm.

The smaller the distance, the smaller the volume that is spanned between the bond conductors and the smaller the parasitic induction.

According to a preferred embodiment, the conductor tracks are arranged closely adjacent to each other with their broad side with an insulation layer in between.

By the adjacent arrangement the parasitic induction can be further reduced, because the mean distance of the cross-section of the two conductor tracks will be smaller than, for example, when the conductor tracks are arranged in each other with their thin side.

The insulation layer comprises an insulation material, such as PET, air, and/or can comprise a vacuum.

Preferable one of the conductor tracks is at least partially arranged between another conductor track and the surface of the carrier board.

This will reduce the space which is occupied by the conductor tracks. Furthermore the conductor tracks are easier to produce, because the flat side is parallel to the contact parts towards a substrate or the power chips.

A process for manufacturing an electrical interconnection structure is characterised by the fact that the conductor tracks are successively attached to contact points on the carrier board by a sintering process. Preferably, an interconnection structure as described above is fabricated.

By fixing the conductor tracks one after the other, connection structures can be created which are not possible by wirebonds or processes.

Soldering processes are characterised by the fact that the connection points are produced at the same time, as the connection is a fusion connection and there is a risk that a first connection structure would be melted when a second connection is melted in a successive fusion process.

Wirebonds, on the other hand, are very fragile. In addition, the wirebonds are flexible and can bend due to shocks and movements, such as those caused by a following manufacturing process.

The invention is explained in more detail below by way of example with reference to the examples shown in the drawings.

The drawings schematically shows:
- Figure 1: an embodiment of a power module in perspective view, which is not part of the invention and serves only for general technical explanation,
- Figure 2: a side view of the power module from Figure 1,
- Figure 3: a perspective view of an embodiment of two power units of a power module in the area of the carrier board, which corresponds to the embodiment in Figures 1 and 2,
- Figure 4: a side view of one of the power units from Figure 3, and
- Figure 5: a section of a power module in the area of busbars, which is designed according to the invention and otherwise corresponds to the embodiment from Figures 1 to 4, and
- Figure 6: an equivalent circuit diagram of a power unit of the power module from Figures 3 to 5.

The power module 1 comprises six power units 2 which are arranged in three groups 16 and connected in parallel.

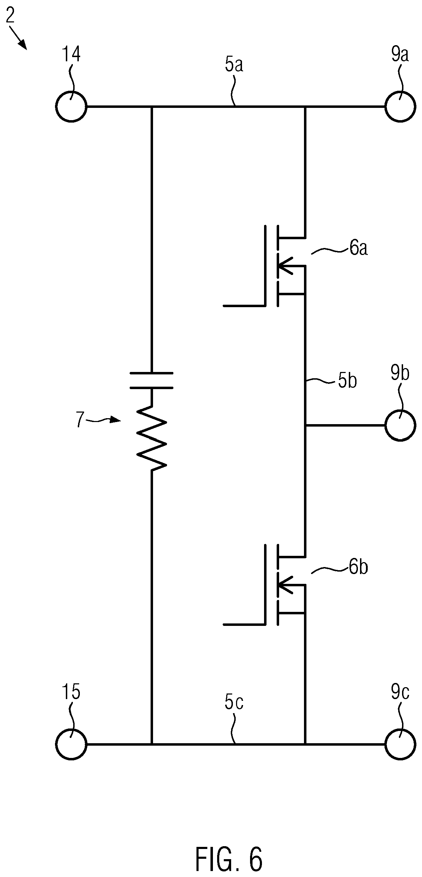

Each power unit 2 forms a power transistor, in particular an NPN transistor (see Figure 6).

The power module 1 has a carrier plate 3 on which the components of the individual power units 2 are arranged. The carrier plate 3 is made of a heat conductor, in this case copper alloy, in order to dissipate the temperatures generated by the power module 1.

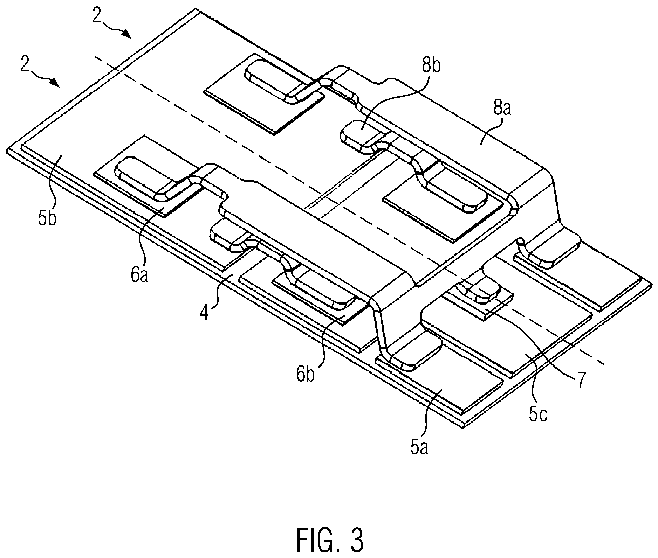

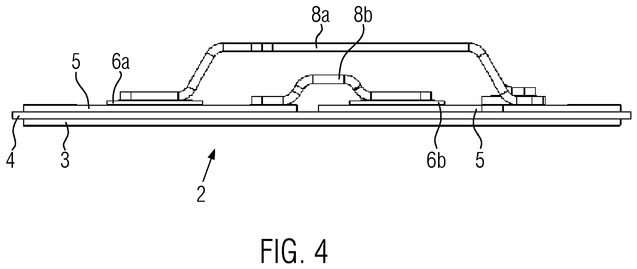

An insulating layer 4 is arranged on the carrier plate 3 to electrically insulate the electrical components from the conductive carrier plate 3. The insulating layer 4 is made of aluminium nitrite (AIN) or aluminium oxide (Al2O3) (figure 3 and 4).

Three electrically conductive substrates 5a, 5b and 5c are arranged on the insulating layer 4 for each power unit 2, whereby two power units 2 of the same group share the substrate 5c in each case.

The substrates 5a, 5b, 5c are formed of copper alloy in order to be able to conduct current effectively.

On each of the two substrates 5b and 5c a power chip 6 is arranged, which are semiconductor diodes. The power chip 6a is arranged on the substrate 5b and the power chip 6b on the substrate 5c.

Conductor tracks 8 connect the individual substrates 5 with the power chips 6.

A first conductor track 8a connects the first substrate 5a to the upper surface of the first power chip 6a.

A second conductor track 8b connects the second substrate 5b on which the first power chip 6a is arranged to the upper surface of the second power chip 6b.

The first power chip 6a and the second power chip 6b are electrically connected with their bottom surfaces to the corresponding substrates 5b and 5c.

The electrical path starts at the first substrate 5a which is electrically connected to the first power chip 6a via the first conductor track 8a. From there, the current travels further to the second substrate 5b. From the second substrate 5b, the current flows via the second conductor track 8b to the second power chip 6b and travels through this to the third substrate 5c.

Thus, the power chips 6 are arranged in such a way that each power unit 2 forms an NPN transistor. For this purpose, the first power chip 6a is an NP semiconductor diode and the second power chip 6b as a PN semiconductor diode. Such a circuit with the function of an NPN transistor can be used to switch and amplify signals with high currents. The corresponding equivalent circuit is shown in Fig. 6.

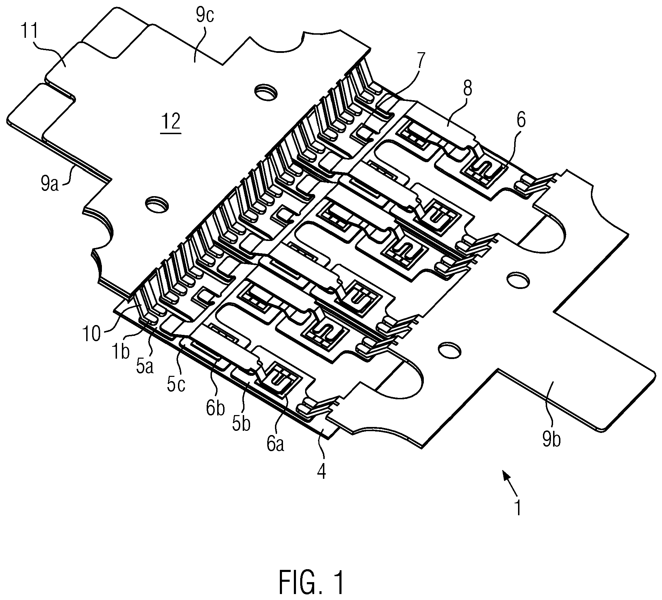

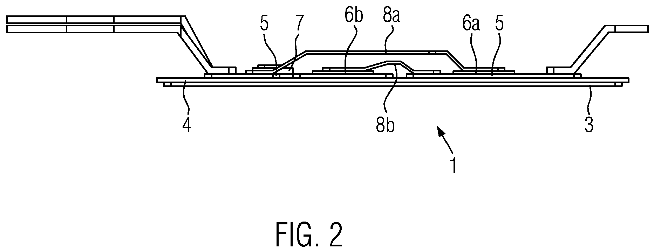

Each of two power units 2 form the power group 16, wherein the power units 2 of one power group 16 share the substrate 5c (figure 1 and 2) and an integrated component 7 arranged on the substrate 5c.

The conductor tracks 8 are each formed of a plate-shaped electrically conductive body which is made of a metal that is a good conductor of electricity. The metal is, for example, a copper alloy or aluminium alloy.

The first conductor track 8a comprises an arching section 17, which extends over the second power chip 6b (Fig. 4). The two arching sections 17 of the conductor track 8a of a power group 16 are connected to each other via a cross-connection 18 in the neighbouring area above a gap in between the first substrate 5a and third substrate 5c. The cross-connection comprises a contact surface in the middle in between the two arching sections 17 which is connected to the integrated component 7.

The second conductor track 8b comprises also an arching section 19 extending over a gap in between the second substrate 5b and the third substrate 5c (Fig. 4).

The thickness and width of the bridges of the conductor tracks 8 are 0.2 mm in the present embodiment to 0.8 mm thick and 1 to 10 mm wide respectively.

The first and second conductor tracks 8a, 8b have contact surfaces from which the arching sections 1, 19 rise at a predetermined pitch and then run substantially parallel to the carrier plate 3 over a predetermined distance. In the present embodiment, the length being around 17 mm and the pitch around 15 mm.

The arching section 19 of the second conductor track 8b is arranged between the arching section 17 of the first conductor track 8a and the carrier plate 3, so that the two conductor tracks 8 run essentially parallel as a stacked arrangement. The conductor tracks 8 are arranged in close proximity to one another with or without an insulating layer between them, whereby the plate-shaped arching sections 17, 19 are arranged approximately parallel with their wide surfaces facing one another and are connected to the substrates 5a, 5b, 5c and the power chips 6a, 6b in such a way that they conduct current antiparallel. This avoids parasitic inductions.

The distance between the two arching section 17, 19 in the area where they run parallel is about 0.5 mm in the present embodiment but may vary between 0.1 and 1.5 mm.

The conductor tracks 8a, 8b are electrically and mechanically connected to the substrates 5a, 5b, 5c and the power chips 6a, 6b by means of sintered interconnection structures.

By using sintered interconnection structures, the individual interconnection conductors 8a, 8b can be successively connected to the substrates 5a, 5b, 5c and power chips 6a, 6b, since once a sintered interconnection structure has been created, it will not be dissolved when heated again such as a soldering connection.

The power module 1 further comprises three busbars 9a, 9b, 9c, each of which is electrically connected to one of the substrates 5a, 5b, 5c via internal contact tongues 10.

The bus bars 9a, 9b, 9c serve as connection elements for connecting the power module 1 to power lines (not shown) for carrying current with a high current value. The power module 1 is designed to switch currents of up to 150 A. The current strengths of the currents that are supplied to or drained from the power module via the bus bars 9a, 9b, 9c are accordingly high.

The busbars 9a, 9b, 9c are plate-shaped bodies made of an electrically highly conductive material, in particular metal. The busbars 9a, 9b, 9c consist, for example, of a copper alloy or aluminium alloy. The busbars 9a, 9b, 9c each have a base section 12 which merges into an external contact tongue 11 on one side and has several internal contact tongues 10 on the other side. The internal contact tongues 10 are angled relative to the respective base section 12 of the busbars 9a, 9b, 9c and each have an angled contact foot 13 at their ends remote from the base section 12.

Each busbar 9a, 9b, 9c is connected to the respective substrate 5 via two internal contact tongues 10 for each power unit 2. Because the third substrate 5c is a common component of two power units 2 of the same power group 16, the connection to the busbar 9c comprises four internal contact tongues 10 (Fig. 1).

The contact feet 13 are likewise electrically and mechanically connected to the substrates 5a, 5b, 5c by means of a sintered connection structure, as are the ends of the conductor tracks 8a, 8b, 8c.

Due to the angled shape of the internal contact tongues 10 relative to the base sections 12 of the busbars 9a, 9b, 9c, the busbars 9a, 9b, 9c are arranged with their base sections 12 and the external contact tongues 11 approximately parallel to the plane of the carrier plate 3, but offset a little with respect to the plane of the carrier plate 3. This creates space in the area of the external contact tongues 11 for contacting them with a high-current connector which encloses the external contact tongues 11.

The first and the third busbars 9a and 9c are arranged with their respective base section 8 and with their external contact tongues 11, closely spaced from each other, whereby an insulation layer is provided between the busbars. The first and third busbars 9a and 9c are arranged with their broadside surfaces facing each other. The distance between the bus bars 9a and 9c is between 0.05 mm and 0.5 mm, but is 0.1 mm in the presented embodiment.

Because the current is supplied via the first bus bar 9a and the current is drained from the power module 1 via the third bus bar 9c, the current flow in these two bus bars 9a, 9c is directed in an antiparallel manner, whereby a parasitic induction is avoided or at least kept low.

The power module 1 has the second busbar 9b on the edge of the carrier board 2 opposite the first and third busbars 9a, 9c.

The second busbar 9b is used to supply a gate potential of the field effect transistors. The currents that are conducted via this busbar 9b are correspondingly low. No antiparallel routing of a current is necessary here, which is why this busbar 9b is arranged individually and freely protruding on the power module 1.

From the third substrate 5c, current flows via the internal contact tongues 10 to the third bus bar 9c and terminates at the third external contact tongue 11c.

A second circuit goes from the first bus bar 9a to the first substrate 5a, then to the first conductor track 8a and to the integrated component 7, from where the current flows to the third substrate 5c. From here, the current flows through the internal contact tongues 10 back to the third bus bar 9c. In the embodiment described here, the busbar 9a corresponds to the emitter, the busbar 9c to the collector and the busbar 9b to the base of the NPN transistor.

In alternative embodiments, the power unit 2 can also be a FET or MOSFET. In this case, busbar 9a corresponds to the source, busbar 9c to the drain and busbar 9b to the gate of the transistor.

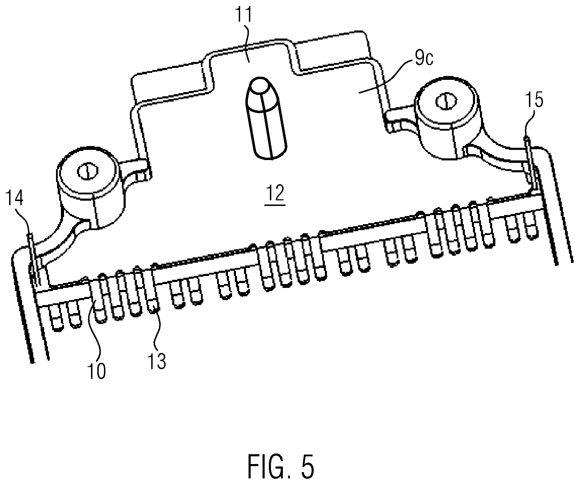

Figures 5 and 6 show an embodiment of the power module 1 which is not the subject matter of claim 1, but which shows the basic structure of such a power module 1.

According to this embodiment example the power module 1 has two terminal pins 14, 15, one terminal pin 14 being formed on the first bus bar 9a and the other terminal pin 15 being formed on the third bus bar 9c. The terminal pins 14, 15 are thin pins which are integrally formed on the busbars 9a, 9c and are made of the same electrically conductive material as the busbars 9a, 9c. The terminal pins 14, 15 have a length such that they project outwards from a housing (not shown) of the power module 1.

The terminal pins 14, 15 are naturally arranged in such a way that they are not in contact with the respective other bus bar 9a, 9c. The terminal pins 14, 15 are preferably located adjacent to the edge or side of the base section 8 of the bus bars 9a, 9c on which the internal contact tongues 10 are formed.

The terminal pins 14, 15 enable 4-point measurement, whereby the voltage between the input and output sides of the power module 1 can be sensed via the terminal pins 14, 15 and the current of the input and output sides of the power module 1 can be sensed via the external contact tongues 11. Since the terminal pins 14, 15 pick off the input and output side of the power module 1 very close to the internal contact tongues 10 and thus very close to the power chips 6 and also pick off in an area in which the bus bars 9a, 9c are arranged very close to each other to avoid parasitic induction, on the one hand the circuit noise, which can never be completely avoided when switching such high currents quickly, is low. On the other hand, the influence of parasitic induction is also low, which means that the voltage in the power module 1 can be measured very precisely.

### Reference signs

- 1: Power module
- 2: Power unit
- 3: Carrier plate
- 4: Insulator layer
- 5: Substrate
- 5a: First substrate
- 5b: Second substrate
- 5c: Third substrate
- 6: Power chips
- 6a: first power chip
- 6b: Second power chip
- 7: Integrated component
- 8: Conductor track
- 8a: First conductor track
- 8b: Second conductor track
- 9: Busbar
- 9a: First busbar
- 9b: Second busbar
- 9c: Third busbar
- 10: Internal contact tongues
- 11: External contact tongues
- 12: Base section
- 13: Contact base
- 14: First terminal pin
- 15: Second terminal pin
- 16: power group
- 17: arching section
- 18: cross-connection
- 19: arching section

## Claims

1. Power module with at least one semiconductor chip (6a, 6b) for high current applications arranged on a carrier board (2), wherein the semiconductor chip (6a, 6b) is electrically connected via conductor tracks (8a, 8b) to two busbars (9a, 9b, 9c) which comprise external contact tongues (11) to be connected to power supply lines,
the busbars (9a, 9b, 9c) being arranged closely adjacent to one another in order to avoid parasitic induction and the current flow in the two busbars (9a, 9b, 9c) being aligned in an anti-parallel manner,
wherein the busbars comprise internal contact tongues (10) and
the internal contact tongues (10) of the different busbars (9a, 9b, 9c) are connected to different electrically conducting substrate sections (5a, 5b, 5c) so that the different substrate sections (5a, 5b, 5c) can be connected to the at least one semiconductor chip (6a, 6b) via pairwise arranged adjacent and in parallel conductor tracks (8a, 8b) in order to avoid parasitic induction, wherein the current flow in the pairwise arranged conductor tracks (8a, 8b) is aligned in an anti-parallel manner.

2. power modules according to claim 1,
**characterized in**
**that** the conductor tracks (8a, 8b) are pairwise arranged adjacent and in parallel in order to avoid parasitic induction and the current flow in the pairwise arranged conductor tracks (8a, 8b) is aligned in an anti-parallel manner and each conductor track (8a ,8b) is formed from a metal plate.

3. power module according to claim 1 or 2,
**characterized in**
the connections to the semiconductor chip (6a, 6b) and to the busbars (9a, 9b, 9c) of the conductor tracks (8a, 8b) each form an electrical and mechanical connection by means of a sintered connection structure.

4. power module according to claim 1 or 3,
**characterized in**
**in that** one of the conductor tracks (8a, 8b) is arranged at least essentially between another conductor track (8a, 8b) and the surface of a carrier board (2) on which the at least one semiconductor chip (6a, 6b) is located,
wherein the conductor tracks (8a, 8b) are at least partially anti-parallel,
such that the parasitic induction induced by the current flow in the conductor tracks (8a, 8b) substantially cancel each other out.

5. Power module according to any one of claims 1 to 4,
**characterized in**
**that** each electrical connection of the electrical connection structure is a connection conductor.

6. Power module according to any one of claims 1 to 5,
**characterized in**
**in that** the conductor tracks (8a, 8b) are each electrically and mechanically connected to the semiconductor chip (6a, 6b) by means of a sintered interconnection structure.

7. Power module according to any one of claims 1 to 6,
**characterized in**
**in that** the conductor track (8a, 8b) is formed from metal, in particular from an aluminium or copper alloy.

8. Power module according to one of claims 1 to 7,
**characterized in**
**in that** the conductor track (8a, 8b) is produced by a pressing process, in particular by a cold pressing process.

9. Power module according to one of claims 1 to 8,
**characterized in**
**in that** the conductor tracks (8a, 8b) are fixed in the electrical connection structure by a sintering process.

10. Power module according to any one of claims 1 to 9,
**characterized in**
**that** the electrical component is an integrated circuit.

11. Power module according to any one of claims 1 to 10,
**characterized in**
**in that** the conductor tracks (8a, 8b) have a height and a width perpendicular to the direction in which the current runs, the height pointing essentially away from the carrier board (2) and
the width being greater than the height, preferably at least 10 times greater and in particular at least 100 times greater.

12. Power module according to any one of claims 1 to 11,
**characterized in**
**that** the distance between the at least two conductor tracks (8a, 8b) is not greater than 1 mm, preferably not greater than 0.5 mm and in particular not greater than 0.1 mm.

13. Power module according to any one of claims 1 to 12,
**characterized in**
**that** two conductor tracks (8a, 8b) are arranged closely adjacent to each other to each other with their broad side with an insulation layer (4) in between.

14. Power module according to any one of claims 1 to 13,
**characterized in**
**that** one of the conductor tracks (8a, 8b) is at least partially arranged between another conductor track (8b, 8a) and the surface of the carrier board.

15. Process for producing a power module in particular according to one of claims 1 to 14,
wherein the conductor tracks (8a, 8b) are successively attached to contact points of the carrier board by a sintering process.

## Patentansprüche

1. Leistungsmodul mit mindestens einem Halbleiterchip (6a, 6b) für Hochstromanwendungen, der auf einer Trägerplatine (2) angeordnet ist, wobei der Halbleiterchip (6a, 6b) über Leiterbahnen (8a, 8b) mit zwei Stromschienen (9a, 9b, 9c) elektrisch verbunden ist, die externe Kontaktzungen (11) aufweisen, die an Stromversorgungsleitungen anzuschließen sind, wobei die Stromschienen (9a, 9b, 9c) eng nebeneinander angeordnet sind, um eine parasitische Induktion zu vermeiden, und der Stromfluss in den zwei Stromschienen (9a, 9b, 9c) antiparallel ausgerichtet ist,
wobei die Stromschienen interne Kontaktzungen (10) aufweisen und die internen Kontaktzungen (10) der verschiedenen Stromschienen (9a, 9b, 9c) mit verschiedenen elektrisch leitenden Substratabschnitten (5a, 5b, 5c) verbunden sind, so dass die verschiedenen Substratabschnitte (5a, 5b, 5c) mit dem mindestens einem Halbleiterchip (6a, 6b) über paarweise angeordnete, benachbarte und parallele Leiterbahnen (8a, 8b) verbunden werden können, um eine parasitische Induktion zu vermeiden,
wobei der Stromfluss in den paarweise angeordneten Leiterbahnen (8a, 8b) antiparallel ausgerichtet ist.

2. Leistungsmodul nach Anspruch 1,
**dadurch gekennzeichnet, dass**
die Leiterbahnen (8a, 8b) paarweise angeordnet, benachbart und parallel sind, um eine parasitische Induktion zu vermeiden, der Stromfluss in den paarweise angeordneten Leiterbahnen (8a 8b) antiparallel ausgerichtet ist und jede Leiterbahn (8a ,8b) aus einer Metallplatte gebildet ist.

3. Leistungsmodul nach Anspruch 1 oder 2,
**dadurch gekennzeichnet, dass**
die Verbindungen der Leiterbahnen (8a, 8b) mit dem Halbleiterchip (6a, 6b) und den Stromschienen (9a, 9b, 9c) jeweils eine elektrische und mechanische Verbindung mittels einer gesinterten Verbindungsstruktur bilden.

4. Leistungsmodul nach Anspruch 1 oder 3,
**dadurch gekennzeichnet, dass**
eine der Leiterbahnen (8a, 8b) zumindest im Wesentlichen zwischen einer anderen Leiterbahn (8a, 8b) und der Oberfläche der Trägerplatine (2), auf der sich der mindestens eine Halbleiterchip (6a, 6b) befindet, angeordnet ist,
wobei die Leiterbahnen (8a 8b) mindestens teilweise antiparallel sind, so dass sich die durch den Stromfluss in den Leiterbahnen (8a, 8b) induzierte parasitische Induktion im Wesentlichen ausgleicht.

5. Leistungsmodul nach einem der Ansprüche 1 bis 4,
**dadurch gekennzeichnet, dass**
es sich bei jeder elektrischen Verbindung der elektrischen Verbindungsstruktur um einen Verbindungsleiter handelt.

6. Leistungsmodul nach einem der Ansprüche 1 bis 5,
**dadurch gekennzeichnet, dass**
die Leiterbahnen (8a, 8b) mit dem Halbleiterchip (6a, 6b) jeweils mittels einer gesinterten Verschaltungsstruktur elektrisch und mechanisch verbunden sind.

7. Leistungsmodul nach einem der Ansprüche 1 bis 6,
**dadurch gekennzeichnet, dass**
die Leiterbahn (8a, 8b) aus einem Metall gebildet ist, insbesondere aus Aluminium oder einer Kupferlegierung.

8. Leistungsmodul nach einem der Ansprüche 1 bis 7,
**dadurch gekennzeichnet, dass**
die Leiterbahn (8a, 8b) durch einen Pressvorgang, insbesondere einen Kaltpressvorgang, hergestellt wird.

9. Leistungsmodul nach einem der Ansprüche 1 bis 8,
**dadurch gekennzeichnet, dass**
die Leiterbahnen (8a, 8b) in der elektrischen Verbindungsstruktur durch einen Sintervorgang befestigt werden.

10. Leistungsmodul nach einem der Ansprüche 1 bis 9,
**dadurch gekennzeichnet, dass**
die elektrische Komponente eine integrierte Schaltung ist.

11. Leistungsmodul nach einem der Ansprüche 1 bis 10,
**dadurch gekennzeichnet, dass**
die Leiterbahnen (8a, 8b) eine Höhe und eine Breite senkrecht zu der Richtung haben, in welcher der Strom verläuft, die Höhe im Wesentlichen von der Trägerplatine (2) weggerichtet ist und die Breite größer als die Höhe ist, vorzugsweise mindestens zehnmal so groß und insbesondere mindestens hundertmal so groß.

12. Leistungsmodul nach einem der Ansprüche 1 bis 11,
**dadurch gekennzeichnet, dass**
der Abstand zwischen den mindestens zwei Leiterbahnen (8a, 8b) nicht größer als 1 mm ist, vorzugsweise nicht größer als 0,5 mm und insbesondere nicht größer als 0,1 mm.

13. Leistungsmodul nach einem der Ansprüche 1 bis 12,
**dadurch gekennzeichnet, dass**
zwei Leiterbahnen (8a, 8b) mit ihrer breiten Seite mit einer Isolierschicht (4) dazwischen eng nebeneinander angeordnet sind.

14. Leistungsmodul nach einem der Ansprüche 1 bis 13,
**dadurch gekennzeichnet, dass**
eine der Leiterbahnen (8a, 8b) mindestens teilweise zwischen einer anderen Leiterbahn (8b, 8a) und der Oberfläche de Trägerplatine angeordnet ist.

15. Verfahren zur Herstellung eines Leistungsmoduls insbesondere nach einem der Ansprüche 1 bis 14,
wobei die Leiterbahnen (8a, 8b) durch einen Sintervorgang nacheinander an Kontaktpunkten der Trägerplatine angebracht werden.

## Revendications

1. Module de puissance comprenant au moins une puce semi-conductrice (6a, 6b) pour des applications à courant élevé, qui est disposée sur une carte support (2), la puce semi-conductrice (6a, 6b) étant reliée électriquement, par l'intermédiaire de pistes conductrices (8a, 8b), à deux barres conductrices (9a, 9b, 9c) qui présentent des languettes de contact externes (11) destinées à être raccordées à des lignes d'alimentation en courant, les barres conductrices (9a, 9b, 9c) étant disposées étroitement les unes à côté des autres afin d'éviter une induction parasite, et l'écoulement du courant dans les deux barres conductrices (9a, 9b, 9c) étant orienté de manière antiparallèle,
les barres conductrices présentant des languettes de contact internes (10), et les languettes de contact internes (10) des différentes barres conductrices (9a, 9b, 9c) étant reliées à différentes sections de substrat électriquement conductrices (5a, 5b, 5c), de sorte que les différentes sections de substrat (5a, 5b, 5c) puissent être reliées à ladite au moins une puce semi-conductrice (6a, 6b) par l'intermédiaire de pistes conductrices (8a, 8b) disposées par paires, adjacentes et parallèles, afin d'éviter une induction parasite,
l'écoulement du courant dans les pistes conductrices (8a, 8b) disposées par paires étant orienté de manière antiparallèle.

2. Le module de puissance selon la revendication 1,
**caractérisé en ce que**
les pistes conductrices (8a, 8b) sont disposées par paires, adjacentes et parallèles afin d'éviter une induction parasite, l'écoulement du courant dans les pistes conductrices (8a, 8b) disposées par paires est orienté de manière antiparallèle, et chaque piste conductrice (8a, 8b) est formée à partir d'une plaque métallique.

3. Le module de puissance selon la revendication 1 ou 2,
**caractérisé en ce que**
les connexions des pistes conductrices (8a, 8b) avec la puce semi-conductrice (6a, 6b) et avec les barres conductrices (9a, 9b, 9c) forment chacun une connexion électrique et mécanique au moyen d'une structure de connexion frittée.

4. Le module de puissance selon la revendication 1 ou 3,
**caractérisé en ce que**
l'une des pistes conductrices (8a, 8b) est disposée au moins essentiellement entre une autre piste conductrice (8a, 8b) et la surface de la carte support (2) sur laquelle se trouve ladite au moins une puce semi-conductrice (6a, 6b),
les pistes conductrices (8a, 8b) sont au moins partiellement antiparallèles, de sorte que l'induction parasite induite par l'écoulement du courant dans les pistes conductrices (8a, 8b) se compense au moins essentiellement.

5. Le module de puissance selon l'une quelconque des revendications 1 à 4,
**caractérisé en ce que**
chaque connexion électrique de la structure de connexion électrique est un conducteur de connexion.

6. Le module de puissance selon l'une quelconque des revendications 1 à 5,
**caractérisé en ce que**
les pistes conductrices (8a, 8b) sont reliées électriquement et mécaniquement à la puce semi-conductrice (6a, 6b) respectivement au moyen d'une structure d'interconnexion frittée.

7. Le module de puissance selon l'une quelconque des revendications 1 à 6,
**caractérisé en ce que**
la piste conductrice (8a, 8b) est formée à partir d'un métal, notamment d'aluminium ou d'un alliage de cuivre.

8. Le module de puissance selon l'une quelconque des revendications 1 à 7,
**caractérisé en ce que**
la piste conductrice (8a, 8b) est réalisée par un procédé de pressage, notamment un procédé de pressage à froid.

9. Le module de puissance selon l'une quelconque des revendications 1 à 8,
**caractérisé en ce que**
les pistes conductrices (8a, 8b) sont fixées dans la structure de connexion électrique par un procédé de frittage.

10. Le module de puissance selon l'une quelconque des revendications 1 à 9,
**caractérisé en ce que**
le composant électrique est un circuit intégré.

11. Le module de puissance selon l'une quelconque des revendications 1 à 10,
**caractérisé en ce que**
les pistes conductrices (8a, 8b) présentent une hauteur et une largeur perpendiculairement à la direction dans laquelle circule le courant, la hauteur est orientée au moins essentiellement à l'opposé de la carte support (2), et la largeur est supérieure à la hauteur, de préférence au moins dix fois supérieure et notamment au moins cent fois supérieure.

12. Le module de puissance selon l'une quelconque des revendications 1 à 11,
**caractérisé en ce que**
la distance entre les au moins deux pistes conductrices (8a, 8b) n'est pas supérieure à 1 mm, de préférence n'est pas supérieure à 0,5 mm et notamment n'est pas supérieure à 0,1 mm.

13. Le module de puissance selon l'une quelconque des revendications 1 à 12,
**caractérisé en ce que**
deux pistes conductrices (8a, 8b) sont disposées étroitement l'une à côté de l'autre par leur côté large, avec une couche isolante (4) interposée.

14. Le module de puissance selon l'une quelconque des revendications 1 à 13,
**caractérisé en ce que**
l'une des pistes conductrices (8a, 8b) est disposée au moins partiellement entre une autre piste conductrice (8b, 8a) et la surface de la carte support.

15. Procédé de fabrication d'un module de puissance, notamment selon l'une quelconque des revendications 1 à 14,
dans lequel les pistes conductrices (8a, 8b) sont appliquées successivement sur des points de contact de la carte support par un procédé de frittage.
